# NEUE EUROPÄISCHE PATENTSCHRIFT

(11) **EP 0 968 567 B2**
(45) Veröffentlichungstag und Bekanntmachung des Hinweises auf die Entscheidung über den Einspruch: **09.01.2008**
(45) Hinweis auf die Patenterteilung: 11.07.2001
(21) Anmeldenummer: 97953925.1
(22) Anmeldetag: 24.12.1997
(51) Int. Cl.: H03K 17/95

(54) **SICHERHEITSSCHALTER**
SAFETY SWITCH
INTERRUPTEUR DE SECURITE

(30) Priorität: 20.03.1997 DE 19711588
(43) Veröffentlichungstag der Anmeldung: 05.01.2000
(73) Patentinhaber: EUCHNER GmbH + Co., 70771 Leinfelden-Echterdingen (DE)
(72) Erfinder: LINK, Walter, D-71277 Rutesheim (DE)
(74) Vertreter: Bartels & Partner
(86) Internationale Anmeldenummer: PCT/EP1997/007302
(87) Internationale Veröffentlichungsnummer: WO 1998/043351

(56) Entgegenhaltungen:
- EP-A- 0 229 247
- EP-B- 0 677 830
- WO-A-92/03876
- DE-A- 4 036 575
- DE-A1- 3 616 389
- DE-A1- 4 412 653
- DE-A1- 19 501 004
- DE-C1- 4 303 367
- PATENT ABSTRACTS OF JAPAN vol. 016, no. 002 (M-1197), 7.Januar 1992 & JP 03 228988 A (DAISHOWA SEIKI CO LTD), 9.Oktober 1991,
- hitag, System Overview, Prospekt der Mikron G.m.b.H., Philips Electronics N.V. 1996, Date of release: 10/96
- Merkblatt für die Auswahl und Anbringung von Näherungsschaltern in Verriegelungseinrichtungen für Sicherheitsfunktionen, Berufsgenossenschaft der Feinmechanik und Elektrotechnik, Fassung 7/96

## Beschreibung

Die Erfindung betrifft einen Sicherheitsschalter.

Mit Sicherheitsschaltern werden bewegliche Schutzeinrichtungen überwacht, beispielsweise Türen und Abdeckungen an Maschinen und Anlagen. Die Schutzeinrichtungen trennen Mensch und Maschine zum gegenseitigen Schutz voreinander. Hierzu müssen die Sicherheitsschalter beim Öffnen einen oder mehrere Stromkreise sicher unterbrechen und solange offenhalten, bis die Schutzeinrichtung wieder geschlossen wird. Elektromechanische Sicherheitsschalter weisen hierfür ein mit dem feststehenden Teil der Schutzeinrichtung verbundenes Schaltglied auf, in welches ein mit der beweglichen Schutzeinrichtung verbundener, separater Betätiger einführbar ist. Dabei schließt der separate Betätiger im eingeführten Zustand die Schalterkontakte, während bei offener Schutzeinrichtung, also ohne eingeführten Betätiger, die Schalterkontakte durch eine formschlüssige Kraftübertragung zwangsweise geöffnet sind. In Anwendungsfällen, in denen aus extremen hygienischen oder anderen Umgebungsbedingungen keine elektromechanischen Sicherheitsschalter eingesetzt werden können (Lebensmittelverarbeitung, Reinigungsanlagen), werden Betätiger mit mehreren Permanentmagneten eingesetzt, welche berührungslos mit Leseköpfen zusammenwirken, in denen Spulen vorgesehen sind. Aus Sicherheitsgründen müssen dabei mindestens drei Magnete vorgesehen sein. Gegenüber dem elektromechanischen Sicherheitsschalter sind die Magnet-Sicherheitsschalter wesentlich empfindlicher für Erschütterungen. Darüber hinaus ist bei einem Ausfall die bevorzugte Reaktion, daß der Schalter sich nicht öffnet.

Die EP 0 229 247 A2 zeigt einen berührungslosen Signalgeber zur Abgabe eines Signals bei genügender Annäherung eines zweiten Teils an einen ersten Teil, der eine erste Sendeeinrichtung für ein Grundsignal und eine zweite Empfangseinrichtung zum Empfang eines ersten Signals aufweist, wobei der zweite Teil zum Empfang des Grundsignals mit einer ersten Empfangseinrichtung versehen ist, von der in Reaktion auf das Grundsignal eine Signalerzeugungseinrichtung zur Erzeugung des ersten Signals und eines zweiten Signals, welches dem ersten Signal aufprägbar ist, beaufschlagbar ist, und der Signalerzeugungseinrichtung eine zweite Sendeeinrichtung nachgeschaltet ist, deren Signal von der zweiten Empfangseinrichtung im ersten Teil aufnehmbar ist. Das zweite Signal kann zur Identifizierung eines bestimmten zweiten Teils genutzt werden, insbesondere ein Kennwert umfassen, das -einstellbar mechanisch codierbar ist.

Der Erfindung liegt daher die Aufgabe zugrunde, einen Sicherheitsschalter der eingangs genannten Art zu verbessern. Diese Aufgabe wird erfindungsgemäß gelöst durch die Merkmale des Anspruches 1. Vorteilhafte Ausgestaltungen sind Gegenstand der Unteransprüche.

Dadurch, daß das Betätigerelement für das Zusammenwirken mit dem Lesekopf eine Induktivität aufweist, sind keinerlei Permanentmagneten im Betätiger mehr notwendig. Dadurch wird der Sicherheitsschalter unempfindlich gegenüber Erschütterungen. Gleichzeitig entfällt auch das Problem, daß die Magnete einen inhomogenen Ansprechbereich haben, was sich beim seitlichen Anfahren als störend auswirkt. Da bei einem Ausfall der Induktivität der Lesekopf kein Vorhandensein eines Betätigerelementes feststellen kann, geht der Sicherheitsschalter dann in den sicheren, also geöffneten Zustand über.

Damit bietet eine Induktivität eine größere Sicherheit als die drei Permanentmagneten. Durch die relativ großen zulässigen mechanischen Toleranzen zwischen Betätigerelement und Lesekopf ist ein Einsatz des erfindungsgemäßen Sicherheitsschalters auch an schweren Schutztüren möglich.

Vorteilhafterweise weist der Lesekopf ebenfalls eine Induktivität auf, welche über ein magnetisches Wechselfeld mit der Induktivität des Betätigerelementes zusammenwirkt. Die beiden Induktivitäten bilden dann einen Transformator. Dieser Transformator kann mit dem sicherheitstechnischen Prinzip der dynamischen Signalübertragung betrieben werden. Dieses erlaubt, auch bei sehr hohen Sicherheitsanforderungen mit einer einkanaligen Struktur zu arbeiten. Damit vereinfacht und verbilligt sich die Herstellung des Lesekopfes.

Besonders vorteilhaft ist, daß das Betätigerelement seine Energie zum Betrieb diesem magnetischen Wechselfeld entnimmt, weil dann keine eigene Spannungsversorgung für das Betätigerelement notwendig ist. Damit wird die Wahrscheinlichkeit eines technischen Ausfalls der Induktivität (mit der Folge eines Übergangs des Sicherheitsschalters in den geöffneten Zustand) stark vermindert, und dadurch auch der entsprechende Wartungsaufwand des Betätigers.

Gemäß der Erfindung enthält das Betätigerelement in einem Speicher eine elektronische Codierung, welche das Betätigerelement eindeutig identifiziert. Damit ist jedes Betätigerelement ein Unikat, wodurch Manipulationen des Sicherheitsschalters mit Hilfe eines anderen Betätigerelementes ausgeschlossen sind. Zugleich ist dadurch eine digitale Auswertung möglich anstelle einer analogen Auswertung über eine Frequenzverschiebung. Ähnliche Betätigerelemente werden für Identifikationssysteme eingesetzt, bei denen bewegliche Werkzeuge oder Werkstückpaletten ein solches Betätigerelement tragen, welches von SchreibLeseköpfen abgefragt und gegebenenfalls umprogrammiert wird, um einer Maschine Anweisungen für die Bewegung oder den Transport dieser Teile zu liefern.

Dem Lesekopf ist eine Auswerteeinrichtung nachgeschaltet, welche in wenigstens einem weiteren Speicher eine elektronische Codierung enthält, welche den Lesekopf bzw. das Schaltglied eindeutig identifiziert. Dadurch ist auch jeder Sicherheitsschalter ein Unikat. In Kombination mit einem eindeutig identifizierbaren Betätigerelement wird erreicht, daß jeder einzelne Sicherheitsschalter nur auf ein einziges Betätigerelement reagiert. Hierzu ist in der Auswerteeinrichtung eine Vergleichseinrichtung vorgesehen, welche die vom Betätigerelement abgegebene Codierung mit der selber gespeicherten Codierung vergleicht. Vorzugsweise wird dabei die Codierung vom Betätigerelement auf Anregung des Lesekopfs hin abgegeben und von letzterem aufgenommen. Ähnliche Systeme unter der Bezeichnung Transponder können auch für elektronische Wegfahrsperren von Automobilen eingesetzt werden, beispielsweise in Verbindung mit Zündschlüsseln.

Der Informationsfluß in der Auswerteeinrichtung erfolgt zweikanalig. Dies wird dadurch erreicht, daß die Teile der Auswerteeinrichtung, die für die Auswertung des vom Lesekopf aufgenommenen Signales zuständig sind, mindestens doppelt vorhanden sind.

Unter Anwendung einer bewährten Technik kann der Sicherheitsschalter einen schlüsselartigen Betätiger aufweisen, der in das Gehäuse des Schaltgliedes einführbar ist. Eine Anwendung der Erfindung ist, wenn das Betätigerelement auf dem Betätiger vorgesehen ist, während entsprechend der Lesekopf innerhalb des Gehäuses des Schaltgliedes vorgesehen ist. Denkbar wäre aber auch eine vertauschte Anordnung. In Anwendung bekannter Technik kann der Betätiger durch einen Stößel verriegelt werden. Eine weitere Anwendung der Erfindung ergibt sich daher, wenn das Betätigerelement auf diesem Stößel vorgesehen ist, während der Lesekopf innerhalb des Gehäuses des Schaltgliedes angeordnet ist. Auch hier könnten die Anordnungen entsprechend vertauscht sein.

Aus Gründen des Materialpreises kann es vorteilhaft sein, daß der Betätiger nicht aus Metall, sondern aus Kunststoff ausgeführt ist. Ein vorteilhafter Schutz vor einer Fehlfunktion infolge eines Bruches des Betätigers ergibt sich, wenn eine Wickelung der Induktivität des Betätigerelements sich über nahezu die gesamte Länge des Betätigers erstreckt.

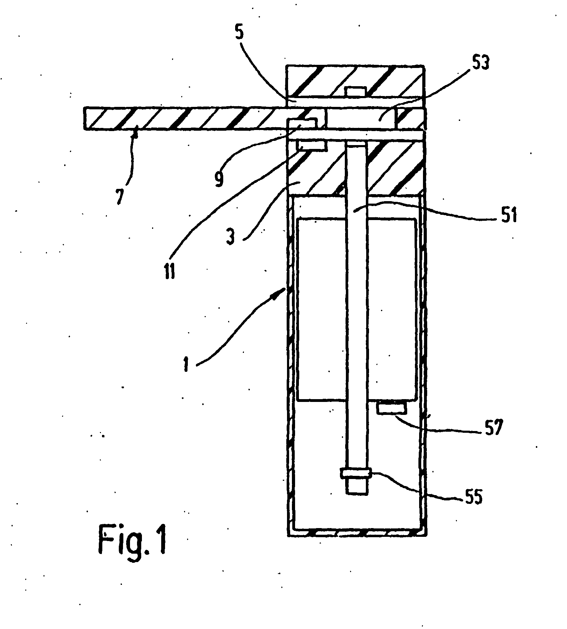

Im folgenden ist die Erfindung anhand eines in der Zeichnung dargestellten Ausführungsbeispiels näher erläutert. Es zeigen
- Fig. 1: einen Schnitt durch das Ausführungsbeispiel,

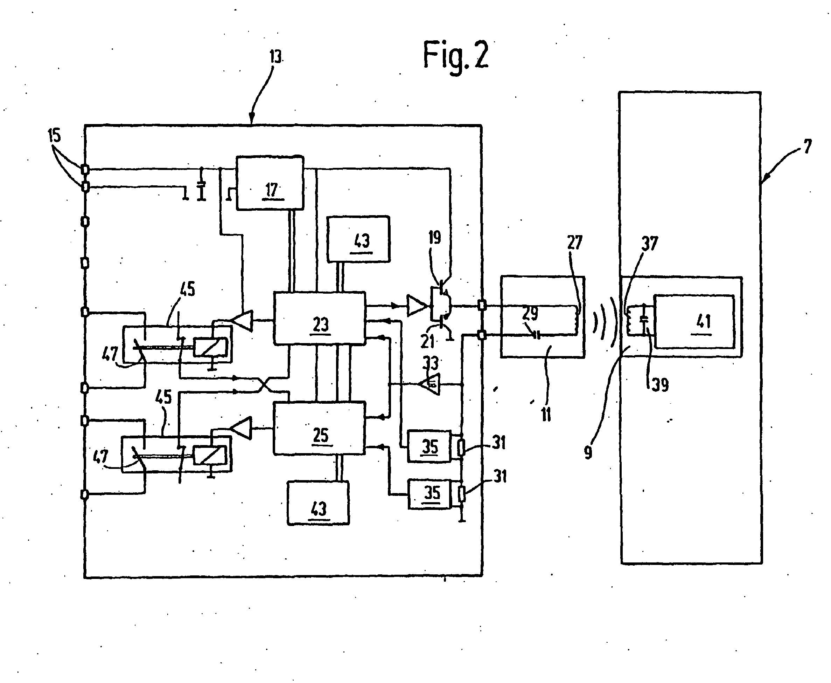

- Fig. 2: ein Blockschaltbild von Betätigerelement, Lesekopf und Auswerteeinrichtung,

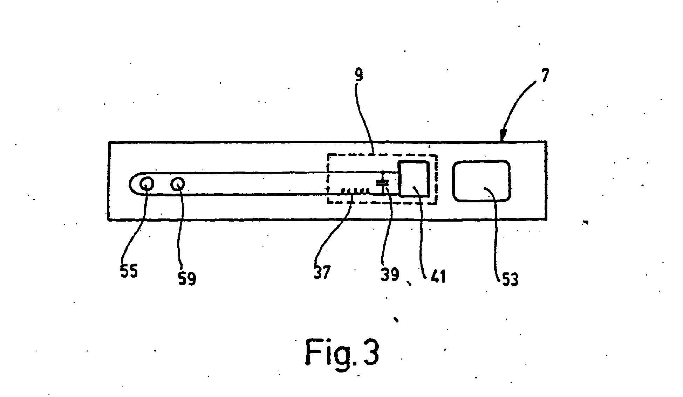

- Fig. 3: eine schematisierte Darstellung des Betätigers.

Ein erfindungsgemäßer Sicherheitsschalter besteht aus einem Schaltglied 1 mit einem Gehäuse 3, welches mit dem feststehenden Teil einer Schutzeinrichtung verbindbar ist. Das Gehäuse 3 wird im Kopfbereich durchdrungen von einem Betätigerkanal 5, welcher an beiden Enden offen ist. In den Betätigerkanal 5 ist ein schlüsselartiger Betätiger 7 einführbar, der an dem beweglichen Teil einer Schutzeinrichtung befestigbar ist, beispielsweise an einer Türe oder Haube. Der Betätiger 7 trägt ein in Kunststoff gekapseltes Betätigerelement 9, welches sich innerhalb des Betätigerkanales 5 befindet, wenn der Betätiger 7 vollständig in den Betätigerkanal 5 eingeführt wird. Das Schaltglied 1 weist am Rande des Betätigerkanales 5 einen Lesekopf 11 auf. Bei vollständig eingeführtem Betätiger 7 sind das Betätigerelement 9 und der Lesekopf 11 einander gegenüberliegend angeordnet und können miteinander wechselwirken.

Der Lesekopf 11 ist an eine Auswerteeinrichtung 13 angeschlossen. Die Auswerteeinrichtung 13 weist Anschlüsse 15 auf, an die eine Geräteversorgungsspannung von 24 V angelegt ist. Mit diesen Anschlüssen 15 sind die Eingänge eines Reglers 17 verbunden. Der Ausgang des Reglers 17 gibt eine interne Versorgungsspannung von 5 V ab. An dieser sind der Kollektor eines npn-Transistors 19, dem ein pnp-Transistor 21 nachgeschaltet ist, sowie ein erster und, aus Sicherheitsgründen, ein zweiter Mikroprozessor 23 bzw. 25 angeschlossen. Der erste Mikroprozessor 23 wird über eine Steuerleitung zusätzlich vom Regler 17 überwacht. Ein Ausgang des ersten Mikroprozessors 23 ist über einen Verstärker an die Basen der Transistoren 19 und 21 angeschlossen. Während der Kollektor des pnp-Transistors 21 auf Masse liegt, führt von den beiden miteinander verbundenen Emittern der Transistoren 19 und 21 eine Leitung in den Lesekopf 11 und ist dort an eine Spule 27 angeschlossen. Diese Spule 27 ist innerhalb des Lesekopfes 11 auf der dem Betätigerkanal 5 zugewandten Seite angeordnet und verläuft mit ihrer Längsachse parallel zu diesem. Der Spule 27 ist ein Kondensator 29 nachgeschaltet, der einerseits über zwei Widerstände 31 auf Masse liegt, und andererseits über einen Empfangsverstärker 33 mit Bandpaßfilter an je einem Eingang der beiden Mikroprozessoren 23 und 25 angeschlossen ist. Parallel zu jedem der beiden Widerstände 31 ist aus Sicherheitsgründen jeweils eine Pegelüberwachung 35 angeschlossen, von denen eine an einen Eingang des ersten Mikroprozessors 23 und die andere an einen Eingang des zweiten Mikroprozessors 25 angeschlossen ist.

Der erste Mikroprozessor 23 generiert aus dem Rechnertakt eine Frequenz von 125 kHz, mit der er die beiden Transistoren 19 und 21 ansteuert, welche abwechselnd vom gesperrten in den gesättigten Zustand schalten. Durch diesen Takt wird der aus der Spule 27 und dem Kondensator 29 bestehende Schwingkreis, dessen Resonanzfrequenz ebenfalls 125 kHz beträgt, zu Schwingungen angeregt. Dabei strahlt die Spule 27 ein magnetisches Wechselfeld ab. Die Widerstände 31 begrenzen den Strom im Schwingkreis und damit die Amplitude des magnetischen Wechselfeldes. Zugleich wird auch der Abstand zwischen Betätigerelement 9 und Lesekopf 11 festgelegt, bei dem beide noch zusammenwirken können. Da die Widerstände 31 doppelt vorhanden sind, können die Pegelüberwachungen 35 durch Vergleich eine Drift eines der Widerstände 31 erkennen.

Im Betätigerelement 9 ist als Induktivität eine Betätigerspule 37 vorgesehen, welche auf der dem Lesekopf 11 zugewandten Seite in Längsrichtung des Betätigers 7 angeordnet ist. Die Betätigerspule 37 bildet zusammen mit einem Betätigerkondensator 39 einen Schwingkreis, zu dem ein IC-Baustein 41 parallel liegt. Wenn bei vollständig eingeführtem Betätiger 7 das Betätigerelement 9 und der Lesekopf 11 einander gegenüberliegen, bilden die Spule 27 und die Betätigerspule 37 einen Transformator, also einen Übertrager. Da zwischen den beiden Spulen 27, 37 ein Spalt vorhanden ist, weist der Transformator einen geringen Kopplungsgrad auf (typischerweise zwischen 0,01 und 0,1). Das von der Spule 27 abgestrahlte magnetische Wechselfeld induziert in der Betätigerspule 37 eine Spannung und erregt somit im Schwingkreis 37, 39 eine Schwingung. Der IC-Baustein 41 weist einen Gleichrichter auf, wodurch er dem Schwingkreis 37, 39 Energie entnehmen kann. Ferner weist der IC-Baustein 41 einen EEPROM auf, der einen 32 Bit langen Code speichert, mit dem das Betätigerelement 9 eindeutig identifizierbar ist. Der IC-Baustein 41 moduliert mit diesem Code die Amplitude im Schwingkreis 37, 39 mit einer Rate von 1 Bit pro msec. Die Betätigerspule 37 koppelt zurück auf die Spule 27 im Lesekopf 11, wodurch dessen Schwingkreis 37, 39 ebenfalls moduliert wird. Über den Empfangsverstärker 33 wird dieses modulierte Signal den Mikroprozessoren 23 und 25 zugeführt.

Jeder der beiden Mikroprozessoren 23 und 25 weist einen EEPROM 43 auf, in dem ein 32 Bit langer Code gespeichert ist, mit dem der Lesekopf 11 eindeutig identifizierbar ist. Die beiden Mikroprozessoren 23 und 25 stellen unabhängig voneinander fest, ob vom Betätigerelement 9 überhaupt ein Code übertragen wird, und ob dieser zu demjenigen Code aus dem EEPROM 23 paßt, also ob das einander zugehörige Paar von Betätigerelement 9 und Lesekopf 11 gegenüberliegt. Nur im letztgenannten Fall gibt der Mikroprozessor 23 bzw. 25 über einen Verstärker einem Relais 45 das Signal zum Schließen eines Schalters 47. Zur größeren Sicherheit sind dabei zu den Schließen der Schalter 47 zwangsgeführte Öffnerkontakte und Leitungen vorgesehen, mit denen jeder Mikroprozessor 23 und 25 den Schaltzustand des jeweiligen anderen Relais 45 feststellen kann. Die beiden Schalter 47 bilden die Ausgänge des Sicherheitsschalters und werden beispielsweise in Serie geschaltet dazu verwendet, die Spannungszufuhr der mit der Schutzeinrichtung versehenen Maschine zu steuern. Ist der Abstand zwischen Betätigerelement 9 und Lesekopf 11 zu groß, also beispielsweise bei nicht in den Betätigerkanal 5 eingeführtem Betätiger 7 (d.h. einer geöffneten Schutzeinrichtung), können die Mikroprozessoren 23, 25 keine passenden Codes feststellen, so daß sie das Signal zum Öffnen der Schalter 47 und damit zum Abschalten der Spannungszufuhr der Maschine geben.

Zur Erhöhung der Sicherheit weist das Schaltglied 1 einen in Längsrichtung des Gehäuses 3 verschiebbaren Stößel 51, der vorzugsweise als Anker eines Hubmagneten ausgebildet ist. Der Stößel 51 kann den senkrecht zu seiner Bewegungsrichtung verlaufenden Betätigerkanal 5 durchqueren und auf der gegenüberliegenden Seite in eine Ausnehmung des Gehäuses 3 eingreifen. Der Betätiger 7 weist eine Öffnung 53 auf, durch die der Stößel 51 greifen kann, wenn der Betätiger 7 vollständig in den Betätigerkanal 5 eingeführt ist. Der Stößel 51 ist entgegen der Hubrichtung des Magneten federbelastet. Die Anordnung und die Ansteuerung des Hubmagneten ist dabei so gewählt, daß bei vollständig in den Betätigerkanal 5 eingeführtem Betätiger 7 der Stößel 51 unter Durchgreifen der Öffnung 53 in die Ausnehmung im Kopf des Gehäuses 3 eingreift und den Betätiger 7 verriegelt. Der Stößel 51 gibt dabei den Betätiger 7 nach Abschalten der Maschine erst wieder frei, wenn die Maschine zum Stillstand gekommen ist, so daß verhindert wird, daß die Schutzeinrichtung bereits geöffnet werden kann während des Auslaufens der Maschine. Zur Positionsüberwachung des Stößels 51 weist dieser ein weiteres Betätigerelement 55 auf, das wie das Betätigerelement 9 ausgebildet ist. Ferner weist das Schaltglied 1 im Gehäuse 3 einen weiteren Lesekopf 57 auf, der wie der Lesekopf 11 ausgebildet ist. Das weitere Betätigerelement 55 und der weitere Lesekopf 57 sind dabei so angeordnet, daß sie einander gegenüberliegen, wenn der Stößel 51 den Betätiger 7 verriegelt. Die dem weiteren Lesekopf 57 nachgeschaltete weitere Auswerteeinrichtung weist zwei Schalter auf, die vorzugsweise mit den Schaltern 47 der Auswerteeinrichtung 13 in Serie gelegt werden.

Der Betätiger 7 besteht aus Kunststoff. An dem von der Öffnung 53 abgewandten Ende sind Befestigungslöcher vorgesehen, mit denen der Betätiger 7 am beweglichen Teil der Schutzeinrichtung befestigt wird. Eine aus Kupferdraht bestehende Windung der Betätigerspule 37 ist dabei aus dem Betätigerelement 9 heraus, auf dem Betätiger 7 entlang um die Befestigungslöcher 59 herum und zurück zum Betätigerelement 9 geführt. Die Windung kann auch noch um die Öffnung 53 gelegt sein. Bei einem Bruch des Betätigers 7 wird diese Windung und damit die Betätigerspule 37 aufgebrochen, so daß das Betätigerelement 9 nicht mehr auf das magnetische Wechselfeld des Lesekopfes 11 ansprechen kann. In diesem Fall wird dem Schaltglied 1 eine geöffnete Schutzeinrichtung signalisiert, so daß der Sicherheitsschalter in den sicheren Zustand übergeht, also die Spannungsversorgung der Maschine abschaltet.

## Patentansprüche

1. Sicherheitsschalter zur Überwachung von beweglichen Schutzeinrichtungen mit
a) einem Schaltglied (1), das wenigstens einen Lesekopf (11, 57) aufweist, und
b) einem relativ zum Lesekopf (11, 57) bewegbaren Betätigerelement (9, 55), welches mit dem Lesekopf (11, 57) berührungslos zusammenwirkt, wobei
c) das Betätigerelement,(9, 55) für das Zusammenwirken mit dem Lesekopf (11, 57) eine Induktivität (37) aufweist,
d) der Lesekopf (11,-57) ebenfalls eine Induktivität (27) aufweist, welche über ein magnetisches Wechselfeld mit der Induktivität (37) des Betätigerelements (9, 55) zusammenwirkt,
e) das Betätigerelement (9, 55) seine Energie zum Betrieb dem magnetischen Wechselfeld entnimmt, und
f) dem Lesekopf (11, 57) eine Auswerteeinrichtung (13) nachgeschaltet ist,
g) das Betätigerelement (9, 55) in einem Speicher (41) eine elektronische Codierung enthält, welche das Betätigerelement (9, 55) eindeutig identifiziert,
h) die Auswerteeinrichtung (13) in wenigstens einem weiteren Speicher (43) eine elektronische Codierung enthält, welche den Lesekopf (11, 57) oder das Schaltglied (1) eindeutig identifiziert,
i) der Lesekopf (11, 57) über die das magnetische Wechselfeld für den Betrieb des Betätigerelements (9, 55) aufbauende Induktivität (27) auch ein Signal mit der Codierung des Betätigerelements (9, 55) aufnimmt,
j) diejenigen Teile (23, 25, 35, 43) der Auswerteeinrichtung (13), die für die Auswertung des vom Lesekopf (11, 57) aufgenommenen Signals vorgesehen sind, mindestens doppelt vorhanden sind,
k) und die Auswerteeinrichtung (13) eine Vergleichseinrichtung (23, 25) aufweist zum Vergleich der vom Betätigerelement (9, 55) abgegebenen und vom Lesekopf (11, 57) aufgenommenen Codierung mit der in der Auswerteinrichtung (13) gespeicherten Codierung.

2. Sicherheitsschalter nach Anspruch 1, **dadurch gekennzeichnet, daß** das Betätigerelement (9, 55) die in ihm gespeicherte Codierung auf Anregung des Lesekopfes (11, 57) hin abgibt.

3. Sicherheitsschalter nach Anspruch 1 oder 2, **dadurch gekennzeichnet, daß** ein Betätiger (7) in ein Gehäuse (3) des Schaltgliedes (1) einführbar ist.

4. Sicherheitsschalter nach Anspruch 3, **dadurch gekennzeichnet, daß** das Betätigerelement (9) am Betätiger (7) vorgesehen ist.

5. Sicherheitsschalter nach Anspruch 3, **dadurch gekennzeichnet, daß** das Betätigerelement (55) auf einem den Betätiger (7) verriegelnden Stößel (51) vorgesehen ist.

6. Sicherheitsschalter nach einem der Ansprüche 3 bis 5, **dadurch gekennzeichnet, daß** wenigstens eine Windung der Induktivität (37) des Betätigerelements (9) sich über nahezu die gesamte Länge des Betätigers (7) erstreckt.

7. Sicherheitsschalter nach einem der Ansprüche 1 bis 6 **gekennzeichnet durch** die Verwendung für eine Schutzeinrichtung einer Maschine oder einer Anlage.

## Claims

1. Safety switch for monitoring movable protection devices having
a) a switching member (1) which has at least one reading head (11, 57), and
b) an actuating element (9, 55) which is movable relative to the reading head (11, 57) and which co-operates in a contactless manner with the reading head (11, 57),
wherein
c) the actuating element (9, 55) has an inductor (37) for co-operation with the reading head (11, 57),
d) the reading head (11, 57) also has an inductor (27) which co-operates with the inductor (37) of the actuating element (9, 55) via a magnetic alternating field,
e) the actuating element (9, 55) draws its energy for operation from the magnetic alternating field, and
f) an evaluation device (13) is connected downstream of the reading head (11, 57),
g) the actuating element (9, 55) contains an electronic code in a store (41), which code clearly identifies the actuating element (9, 55),
h) the evaluation device (13) contains an electronic code in at least one other store (43), which code clearly identifies the reading head (11, 57) or the switching member (1),
i) the reading head (11, 57) also receives a signal with the code of the actuating element (9, 55) via the inductor (27) which constructs the magnetic alternating field for operating the actuating element (9, 55),
j) those elements (23, 25, 35, 43) of the evaluation device (13) which are provided for the evaluation of the signal received by the reading head (11, 57) are present at least in duplicate,
k) and the evaluation device (13) has a comparison device (23, 25) in order to compare the code which is emitted by the actuating element (9, 55) and which is received by the reading head (11, 57) with the code stored in the evaluation device (13).

2. Safety switch according to claim 1, **characterised in that** the actuating element (9, 55) emits the code stored therein when the reading head (11, 57) is stimulated.

3. Safety switch according to claim 1 or 2, **characterised in that** an actuator (7) can be introduced into a housing (3) of the switching member (1).

4. Safety switch according to claim 3, **characterised in that** the actuating element (9) is provided on the actuator (7) .

5. Safety switch according to claim 3, **characterised in that** the actuating element (55) is provided on a slide (51) which locks the actuator (7).

6. Safety switch according to any one of claims 3 to 5, **characterised in that** at least one winding of the inductor (37) of the actuating element (9) extends over nearly the entire length of the actuator (7).

7. Safety switch according to any one of claims 1 to 6, **characterised by** the use for a protection device of a machine or an installation.

## Revendications

1. Interrupteur de sécurité pour contrôler des dispositifs de protection mobiles, comprenant
a) un élément de commutation (1) qui a au moins une tête de lecture (11, 57), et
b) un élément d'actionnement (9, 55) mobile par rapport à la tête de lecture (11, 57), lequel coopère sans contact avec la tête de lecture (11, 57),
dans lequel
c) l'élément d'actionnement (9, 55) a une inductance (37) pour la coopération avec la tête de lecture (11, 57),
d) la tête (11, 57) de lecture a également une inductance (27) qui coopère par un champ magnétique alternatif avec l'inductance (37) de l'élément d'actionnement (9, 55),
e) l'élément d'actionnement (9, 55) prélève son énergie pour le fonctionnement du champ magnétique alternatif,
f) un dispositif d'évaluation (13) est monté en aval de la tête de lecture (11, 57),
g) l'élément d'actionnement (9, 55) contient dans une mémoire (41) un codage électronique qui identifie sans équivoque l'élément d'actionnement (9, 55),
h) le dispositif d'évaluation (13) contient dans une moins une autre mémoire (43) un codage électronique qui identifie sans équivoque la tête de lecture (11, 57) ou l'élément (1) de commutation,
i) la tête de lecture (11, 57) reçoit par l'inductance (27) créant le champ magnétique alternatif pour le fonctionnement de l'élément d'actionnement (9, 55) également un signal ayant le codage de l'élément d'actionnement (9, 55),
j) les parties (23, 25, 35, 43) du dispositif d'évaluation (13), qui sont prévues pour l'évaluation du signal reçu par la tête de lecture (11, 57), sont présentes au moins en double,
k) et le dispositif d'évaluation (13) a un dispositif (23, 25) de comparaison pour comparer le codage émis par l'élément d'actionnement (9, 55) et le codage reçu par la tête de lecture (11, 57) et mémorisé dans le dispositif d'évaluation (13).

2. Interrupteur de sécurité selon la revendication 1, **caractérisé en ce que** l'élément d'actionnement (9, 55) émet le codage qui y est mémorisé sur excitation de la tête de lecture (11, 57).

3. Interrupteur de sécurité selon la revendication 1 ou 2, **caractérisé en ce qu'**un actionneur (7) peut être introduit dans un boîtier (3) de l'élément de commutation.

4. Interrupteur de sécurité selon la revendication 3, **caractérisé en ce que** l'élément d'actionnement (9) est prévu sur l'actionneur (7).

5. Interrupteur de sécurité selon la revendication 3, **caractérisé en ce que** l'élément d'actionnement (55) est prévu sur un coulisseau (51) verrouillant l'actionneur (7).

6. Interrupteur de sécurité selon l'une quelconque des revendications 3 à 5, **caractérisé en ce qu'**au moins un enroulement de l'inductance (37) de l'élément d'actionnement (9) s'étend sur presque toute la longueur de l'actionneur (7).

7. Interrupteur de sécurité selon l'une quelconque des revendications 1 à 8, **caractérisé par** l'utilisation pour un dispositif de protection d'une machine ou d'une installation.
